# FASCICULE DE BREVET EUROPEEN

(11) **EP 0 391 784 B1**
(45) Date de publication et mention de la délivrance du brevet: **21.06.1995**
(21) Numéro de dépôt: 90400901.6
(22) Date de dépôt: 03.04.1990
(51) Int. Cl.: H04N 5/907, H04N 7/167, G11C 7/00

(54) **Dispositif et procédé de génération de signaux de contrôle**
Einrichtung und Verfahren zur Erzeugung von Steuersignalen
Device and method for generating control signals

(30) Priorité: 04.04.1989 FR 8904404
(43) Date de publication de la demande: 10.10.1990
(73) Titulaire: LABORATOIRE EUROPEEN DE RECHERCHES ELECTRONIQUES AVANCEES, 92400 Courbevoie (FR)
(72) Inventeur: Poivet, Michel, F-92045 Paris la Défense (FR); Guillon, Jean-Claude, F-92045 Paris la Défense (FR); Daniel, Patrick, F-92045 Paris la Défense (FR)
(74) Mandataire: Ruellan-Lemonnier, Brigitte

(56) Documents cités:
- EP-A- 0 119 945
- EP-A- 0 124 942
- EP-A- 0 160 398
- WO-A-88/02955
- FR-A- 2 543 391
- US-A- 4 673 975
- US-A- 4 710 966
- ELECTRONICS LETTERS, vol. 22, no. 2, 16 janvier 1986, pages 102-103, Stevenage, Herts, GB; P. AXON: "Scheme for achieving continuously variable delay in digital test equipment"
- ELECTRONIC DESIGN, vol. 36, no. 11, 12 mai 1988, pages 113-116,118, Hasbrouck Heights, NJ, US; C. JAY et al.: "Use logic cell array to control a large FIFO buffer"
- ELECTRONICS INTERNATIONAL, vol. 55, no. 13, 30 juin 1982, page 121, New York, US; D. VAKILI: "RAM makes programmable digital delay circuit"

## Description

L'invention se rapporte principalement à un dispositif et à un procédé de génération de signaux de contrôle et plus particulièrement des signaux d'autorisation de lecture ou d'écriture des mémoires de lignes dans un dispositif de télévision.

Il est connu de réaliser des récepteurs de télévision comportant des mémoires susceptibles de stocker toute ou partie de l'image à visualiser. Il est notamment connu des dispositifs de télévision comportant une mémoire ligne susceptible de stocker une ligne d'image à projeter. De tels dispositifs présentent l'inconvénient de générer le retard d'une ligne entre la réception et l'affichage. Ce retard peut avoir des conséquences graves dans le cas où il est nécessaire de générer des signaux d'autorisation de lecture ou d'écriture d'une telle mémoire (WRITE ENABLE, READ ENABLE ou W̅E̅ et respectivement R̅E̅ en abréviation, en terminologie anglo-saxonne). La barre supérieure signifie que les signaux sont actifs dans l'état bas. Il est bien entendu que l'utilisation de signaux actifs dans l'état haut ne sort pas du cadre de la présente invention. En effet, dans les dispositifs de type classique on utilise des signaux de synchronisation différents pour effectuer l'écriture et la lecture d'une ligne de l'image. Ainsi, la lecture d'une ligne peut être affectée par le décalage de synchronisation appelé gigue survenant entre deux lignes successives de l'image. Ainsi, par exemple une ligne blanche verticale relue à partir d'un dispositif de type connu comporte des points décalés horizontalement à gauche ou à droite selon le décalage de synchronisation présent. Un dispositif utilisant deux références de temps, l'une pour l'écriture, l'autre pour la lecture d'une ligne est décrit dans le document US-A-4 673 975.

Le dispositif selon la présente invention génère les signaux d'écriture et de lecture d'une mémoire ligne, pour la même information, à partir d'une référence temporelle unique, afin d'éviter l'apparition de ladite gigue affectant les lignes de l'image vidéo.

Dans un premier exemple de réalisation, les signaux écriture et lecture sont directement élaborés à partir d'une même référence temporelle.

Dans une seconde variante de réalisation, le signal d'autorisation d'écriture W̅E̅ est élaboré à partir d'une référence temporelle. Le signal d'autorisation de lecture R̅E̅ est élaboré à partir du signal d'autorisation d'écriture W̅E̅.

Le dispositif selon la présente invention est particulièrement utile dans le dispositif comportant deux mémoires en ligne montées en parallèle chacune étant alternativement en lecture puis en écriture. Un exemple de ce type de dispositif est constitué par le dispositif de désembrouillage d'images de télévision.

L'invention se rapporte principalement à un dispositif d'élaboration de signaux de contrôle d'écriture (W̅E̅) et de lecture (R̅E̅) dans une mémoire d'un élément de signal vidéo, caractérisé par le fait qu'il comporte des moyens d'élaboration desdits signaux de contrôle (R̅E̅, W̅E̅) pour le même élément de signal vidéo, à partir d'une seule référence temporelle.

L'invention se rapporte aussi à un tel dispositif caractérisé par le fait que la référence temporelle est l'impulsion de synchronisation horizontale du signal vidéo.

L'invention se rapporte aussi à un dispositif caractérisé par le fait que les signaux de contrôle peuvent être élaborés directement ou indirectement à partir de la référence temporelle.

L'invention se rapporte aussi à un dispositif caractérisé par le fait que l'élément du signal vidéo est une ligne d'affichage.

L'invention se rapporte aussi à un dispositif caractérisé par le fait qu'il comporte, connectés en série des moyens d'élaboration de la référence temporelle, les moyens d'élaboration du signal de contrôle écriture (W̅E̅) et les moyens d'élaboration du signal de contrôle de lecture (R̅E̅) de façon à ce que le signal de contrôle de lecture (R̅E̅) soit élaboré à partir du signal de contrôle d'écriture (W̅E̅).

L'invention se rapporte aussi à un dispositif caractérisé par le fait que ledit dispositif est un dispositif numérique.

L'invention se rapporte aussi à un dispositif caractérisé par le fait que les moyens d'élaboration de la référence temporelle, les moyens d'élaboration des signaux de contrôle d'écriture (W̅E̅) et/ou les moyens d'élaboration des signaux de contrôle de lecture (R̅E̅) comportent un compteur dont la sortie est connectée à un décodeur.

L'invention a aussi pour objet un dispositif de désembrouillage caractérisé par le fait qu'il comporte deux piles de type premier-entré, premier-sorti (FIFO) travaillant en alternance en écriture et en lecture.

L'invention a aussi pour objet un dispositif de désembrouillage caractérisé par le fait qu'il comporte deux mémoires vives dynamiques travaillant en alternance en écriture et en lecture connectées par un bus d'adresse à un dispositif d'adressage.

L'invention a aussi pour objet un téléviseur caractérisé par le fait qu'il comporte un dispositif de désembrouillage.

L'invention a également pour objet un procédé d'élaboration de signaux de contrôle d'écriture (W̅E̅) et de lecture (R̅E̅) d'une ligne vidéo dans un dispositif de mémorisation caractérisé par le fait qu'il comporte les étapes :
- d'élaboration d'une référence temporelle pour une ligne i
- d'élaboration directement ou indirectement à partir de la référence temporelle de la ligne i du signal de contrôle d'écriture de la ligne i (W̅E̅) et du signal de contrôle de lecture de la ligne i (R̅E̅).

L'invention a aussi pour objet un procédé caractérisé par le fait qu'il comporte les étapes :
- d'élaboration du signal de contrôle d'écriture de la ligne i (W̅E̅) à partir de la référence temporelle de la ligne i
- d'élaboration du signal de contrôle de lecture de la ligne i (R̅E̅) à partir du signal de contrôle d'écriture de la ligne i (W̅E̅).

L'invention a aussi pour objet un procédé caractérisé par contrôle d'écriture (W̅E̅) et de lecture (R̅E̅) de la ligne i directement à partir de la référence temporelle de la ligne i.

L'invention sera mieux comprise au moyen de la description ci-après et des figures annexées données comme des exemples non limitatifs parmi lesquels :
- la figure 1 est un schéma de réalisation d'un premier exemple de réalisation du dispositif selon la présente invention ;
- la figure 2 est un schéma de réalisation d'un deuxième exemple de réalisation du dispositif selon la présente invention ;
- la figure 3 est un schéma de réalisation d'un troisième exemple de réalisation du dispositif selon la présente invention ;
- la figure 4 est un schéma de réalisation d'un dispositif de retard susceptible d'être mis en oeuvre dans le dispositif selon la présente invention ;
- la figure 5 est un schéma illustrant un exemple de fonctionnement du dispositif selon la présente invention ;
- la figure 6 est un schéma illustrant un exemple de fonctionnement du dispositif selon la présente invention ;
- la figure 7 est un schéma d'un exemple de réalisation d'un dispositif de génération des signaux susceptible d'être mis en oeuvre dans le dispositif selon la présente invention ;
- la figure 8 est un schéma d'un quatrième exemple de réalisation du dispositif selon la présente invention ;
- la figure 9 est un schéma d'un cinquième exemple de réalisation du dispositif selon la présente invention ;
- la figure 10 est un schéma explicatif de fonctionnement d'un exemple de réalisation du dispositif selon la présente invention ;
- la figure 11 est un schéma d'un exemple de réalisation du dispositif selon la présente invention correspondant au fonctionnement illustré sur la figure 10.

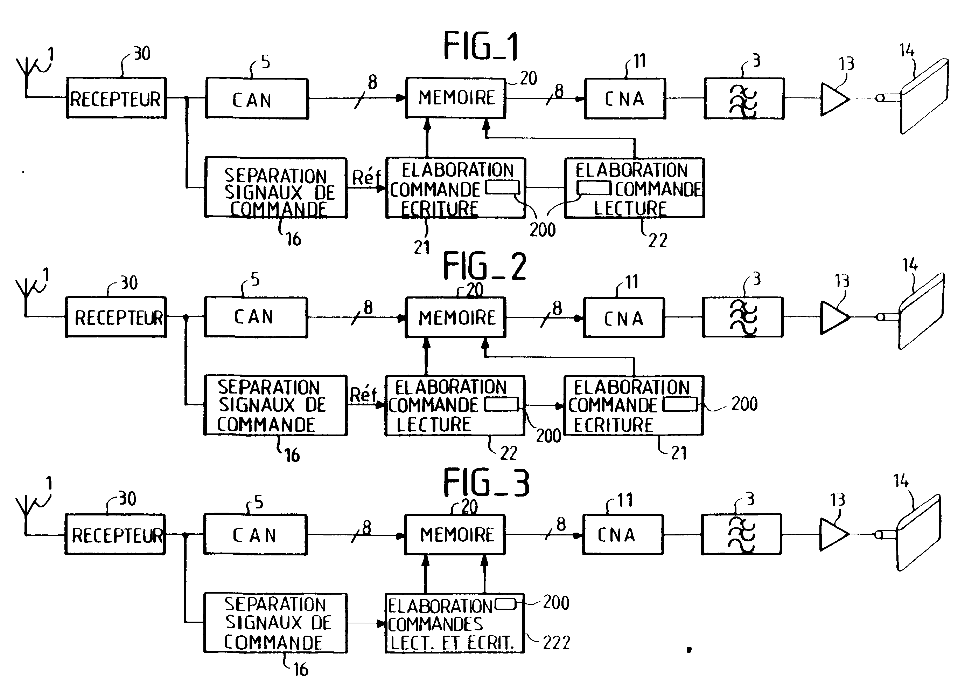

Sur les figures 1 à 10 on a utilisé les mêmes références pour désigner les mêmes éléments.

Sur la figure 1, on peut voir un premier exemple de réalisation de récepteur de télévision selon la présente invention.

Le dispositif de la figure 1 comporte une source 1 de signaux de télévision, par exemple une antenne. L'antenne 1 est branchée à l'entrée d'un récepteur (tuner en terminologie anglo-saxonne) de télévision 30 de type connu. La sortie du récepteur de télévision 30 est branchée d'une part à l'entrée d'un convertisseur analogique-numérique 5 et d'autre part à l'entrée d'un dispositif de séparation des signaux de contrôle 16. La sortie du convertisseur analogique-numérique 5 est connectée par exemple par un bus de 8 bits, à l'entrée d'un dispositif de mémorisation 20. Le dispositif de mémorisation 20 est par exemple une mémoire vidéo, une mémoire dynamique ou une pile de type "premier-entré, premier-sorti" (FIFO en terminologie anglo-saxonne). Avantageusement, le dispositif de mémorisation 20 est du type mémoire ligne c'est-à-dire susceptible de stocker une ligne de balayage d'une image de télévision. La sortie du dispositif de séparation des signaux de contrôle 16 est connectée à l'entrée d'un dispositif 21 d'élaboration de signaux de contrôle d'écriture. La sortie du dispositif d'élaboration de signaux de contrôle d'écriture 21 est connectée d'une part à une entrée de commande du dispositif de mémorisation 20, et d'autre part à l'entrée d'un dispositif d'élaboration de signaux de contrôle lecture 22. La sortie du dispositif d'élaboration de signaux de contrôle lecture 22 est connectée à une entrée de signaux de contrôle du dispositif de mémorisation 20. La sortie du dispositif de mémorisation 20 est connectée à un dispositif d'exploitation des images. Sur l'exemple illustré sur la figure 1, le dispositif d'exploitation comporte un convertisseur analogique-numérique 11, un filtre passe-bas 3, un amplificateur 13 et un tube à rayons cathodiques 14. Il est bien entendu que l'utilisation d'autres dispositifs d'exploitation de l'image ne sortent pas du cadre de la présente invention.

Le récepteur 30 fournit au convertisseur analogique-numérique 5 les signaux actifs destinés au balayage du tube à rayons cathodiques 14 et au dispositif de séparation des signaux de contrôle 16, les signaux de synchronisation et les retours lignes. Le convertisseur analogique-numérique 5 effectue la numérisation des signaux de télévision destinés à être visualisés. Les signaux numérisés par le convertisseur analogique-numérique sont stockés dans le dispositif de mémorisation 20. Le dispositif de séparation des signaux de contrôle 16 est d'abord une référence de temps à partir des signaux de synchronisation fournis par le secteur 30. Le dispositif d'élaboration à signaux de contrôle d'écriture 21 est d'abord une commande d'écriture en mémoire 20. En présence de cette commande les signaux délivrés par le convertisseur analogique-numérique 5 sont mémorisés dans le dispositif de mémorisation 20. Les dispositifs d'élaboration de commande écriture 20 et lecture 22 comportent par exemple un dispositif 200 destiné à générer le retard. Avantageusement, le dispositif 200 est un dispositif de génération de retard numérique. A partir du signal de signaux de contrôle écriture, le dispositif d'élaboration de signaux de contrôle lecture 22 élabore des signaux de contrôle de lecture du dispositif de mémorisation 20. Les signaux de contrôle de lecture de le dispositif de mémorisation 20 permet la lecture de la partie de l'image stockée dans le dispositif de mémorisation 20.

Il est bien entendu que les signaux de contrôle écriture et les signaux de contrôle lecture peuvent ne s'appliquer qu'à une partie du dispositif de mémorisation 20.

Sur la figure 1, on a illustré une variante de réalisation numérique du dispositif selon la présente invention. Il est bien entendu qu'une variante de réalisation analogique des mémorisations et/ou d'élaboration des signaux de contrôle lecture et écriture ne sort pas du cadre de la présente invention.

Dans l'exemple illustré sur la figure 1, le signal de contrôle de lecture est élaboré à partir du signal de contrôle d'écriture du dispositif de mémorisation 20. Ainsi, les variations de synchronisation entre l'écriture et la lecture du dispositif de mémorisation 20 ne risquent pas de provoquer du décalage de l'image stockée dans le dispositif de mémorisation 20.

Sur la figure 2, on peut voir une variante de réalisation du dispositif selon la présente invention dans lequel on élabore le signal de contrôle d'écriture à partir du signal de contrôle de lecture. Dans un tel cas la sortie du dispositif de séparation des signaux de contrôle 16 est connectée à l'entrée du dispositif d'élaboration de signaux de contrôle lecture 22. La sortie du dispositif d'élaboration de signaux de contrôle lecture 22 est connectée d'une part à une entrée du signal de contrôle du dispositif de mémorisation 20 et d'autre part à l'entrée du dispositif d'élaboration de signaux de contrôle écriture 21. La sortie du dispositif d'élaboration de signaux de contrôle écriture 21 est connectée à une entrée de signal de contrôle du dispositif de mémorisation 20.

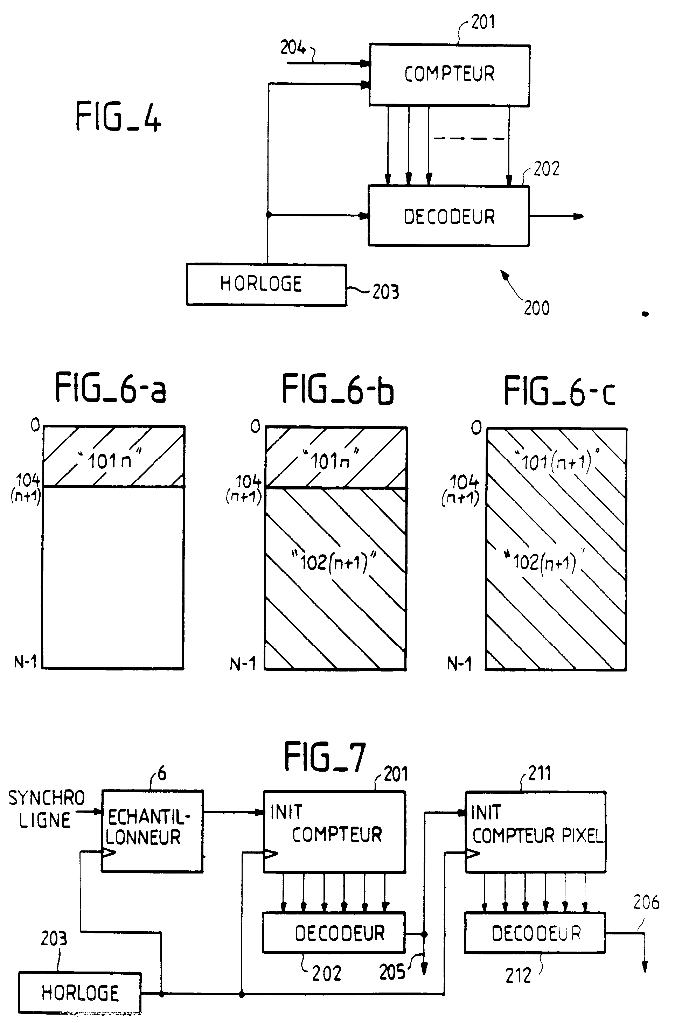

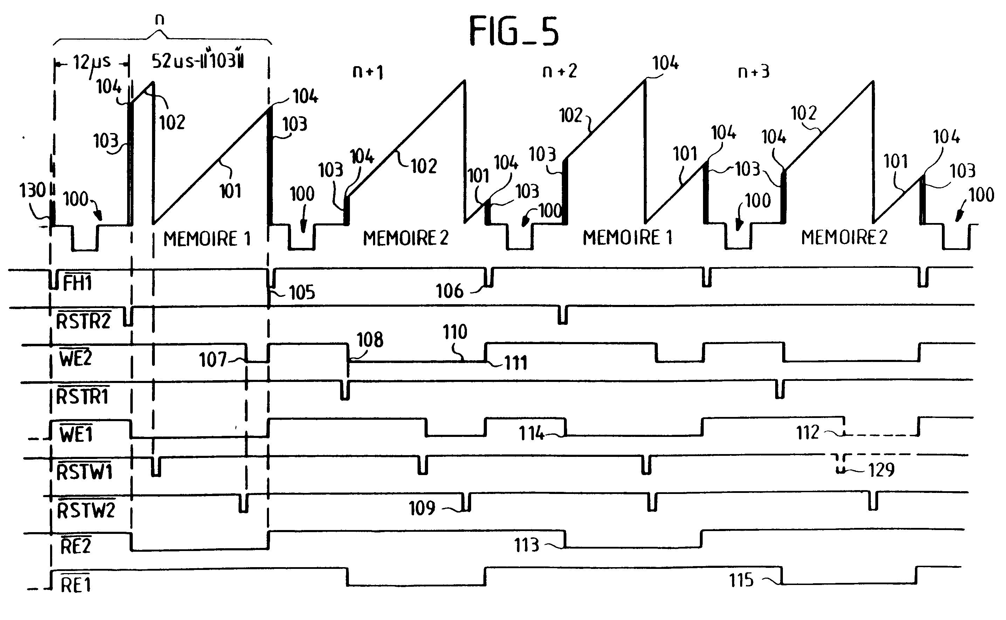

Sur la figure 3, on peut voir un dispositif selon la présente invention comportant un dispositif d'élaboration de signaux de contrôle lecture et écriture 222. Dans le cas illustré sur la figure 3, les signaux de contrôle lecture et écriture sont élaborés par un dispositif unique 222 à partir d'une référence temporelle fournie par le dispositif de séparation de signaux de contrôle 16. Les informations affichées à partir du dispositif de mémorisation 20 sont insensibles à la gigue dans la mesure où le signal de contrôle lecture et le signal de contrôle écriture, d'une même information, ont été élaborés à partir d'une même référence temporelle.

Sur la figure 4 on peut voir un exemple de réalisation d'un dispositif de retard 200 des dispositifs d'élaboration de signaux de contrôle 21,22,222 des figures 1,2 et 3. Le dispositif 200 comporte par exemple un compteur 201 connecté à un décodeur 202. Le compteur 201 et le décodeur 202 reçoivent des signaux d'une horloge 203. Le signal de référence à partir duquel est élaboré le signal de contrôle 204 effectue la remise à zéro du compteur 201. A chaque cycle de l'horloge 203 le compteur 201 est incrémenté, par exemple d'une unité. Le décodeur 202 est prévu pour générer un signal quand le compteur 201 aura atteint une valeur prédéterminée. Cette valeur correspond au nombre de cycles d'horloge de retard du signal désiré par le décodeur 202 par rapport au signal 204. Ainsi, dans l'exemple illustré sur la figure 1, le dispositif d'élaboration du signal de contrôle d'écriture est initialisé par la référence temporelle générée par le dispositif de séparation des signaux de contrôle 16. Au bout d'un nombre de cycles d'horloge 203 prédéterminé le dispositif d'élaboration du signal de contrôle d'écriture 21 génère un signal de contrôle d'écriture fournit simultanément au dispositif de mémorisation 20 ou au dispositif d'élaboration du signal de contrôle lecture 22. Ce signal initialise le compteur du dispositif d'élaboration du signal de contrôle lecture 22. Au bout d'un nombre de cycles d'horloge prédéterminé le dispositif d'élaboration de signal de contrôle lecture 22 génère un signal de contrôle de lecture fourni au dispositif de mémorisation 20. Avantageusement, on utilise une même horloge 203 pour le dispositif 200, le dispositif d'élaboration de signal de contrôle écriture 21 et d'élaboration de signal de contrôle lecture 22.

Le chronogramme de la figure 5, représente des signaux de commande d'un dispositif de désembrouillage selon la présente invention comportant deux mémoires lignes alternativement en écriture ou en lecture (FLIP-FLOP en terminologie anglo-saxonne).

Sur la figure 5, on peut voir un exemple de chronogramme des signaux présents dans le dispositif de désembrouillage d'images de télévision. Dans l'exemple illustré sur la figure 5, le brouillage consiste en une inversion temporelle autour d'un point de coupure variable 104 de la partie active de chaque ligne. Ce type d'embrouillage est connu en soi. Sur la figure 5, le signal vidéo 130 correspond à quatre lignes successives n,n+1,n+2 et n+3. Pour la clarté de la figure on a utilisé un signal qui avant brouillage correspondait à une dent de scie. Dans cet exemple il est extrêmement facile d'identifier sur un chronogramme les diverses parties du signal embrouillé. Il est bien entendu que dans la réalité le signal actif correspondra à une information à transmettre.

Chaque ligne est composée de signaux de contrôle retour ligne 100, du segment 102 de l'image compris entre le point de coupure 104 et la fin de la ligne suivi du segment 101 correspondant au début de la ligne jusqu'au point 104. Le dispositif selon la présente invention s'applique notamment au désembrouillage d'images. La présente invention s'applique notamment à un procédé de brouillage utilisant des zones de recouvrement 103 autour du point de coupure 104 ainsi qu'à un procédé de brouillage n'appliquant l'inversion qu'à une partie du signal pour rendre plus difficile la détection du point de coupure 104. Le dispositif selon la présente invention génère un signal d'horloge F̅H̅1̅, actif à l'état bas, comportant impulsion comme par exemple 105 ou 106 à chaque retour ligne 100.

Le signal R̅S̅T̅R̅2̅ correspond à l'initialisation de l'adresse lecture de la seconde mémoire ligne qui comporte de brèves impulsions pour les lignes paires. On appelle les lignes paires les lignes numérotées n+2K.

Le signal W̅E̅2̅, actif à l'état bas, correspond à l'autorisation d'écriture de la seconde mémoire pour une ligne sur deux. Le signal W̅E̅2̅ comporte une première période active comme par exemple celle commençant au point 107, correspondant à la préparation de la seconde mémoire et une seconde période active entre les points 108 et 111 correspondant à l'écriture d'informations utiles de la seconde mémoire. A partir du point 107 on commence à écrire la fin du segment 101 de la ligne n dans la seconde mémoire. Comme la ligne n correspond à l'information qui normalement doit être stockée dans la première mémoire, l'information stockée dans la seconde mémoire, à ce moment ne sert qu'à la préparation de l'écriture de la ligne n+1. L'écriture de la seconde mémoire s'arrête au moment du retour ligne 100 de la ligne n+1. L'écriture dans la seconde mémoire reprend au point 108 correspondant au point de coupure 104. Par exemple le désembrouillage est effectué lors de l'écriture des première et seconde mémoires. Dans un tel cas entre les points 108 et 110 il est indispensable d'écrire aux adresses correspondant au segment 102. A partir du point 110, correspondant à la fin du segment 102 et jusqu'au point 111 correspondant au point 104 l'écriture dans la seconde mémoire est effectuée à partir de l'adresse 0 jusqu'à celle correspondant au point 104 de la ligne n+1. L'écriture reprend de la même manière pour l'écriture de la ligne n+3 dans la seconde mémoire.

Le signal R̅S̅T̅R̅1̅, actif à l'état bas, comporte des impulsions brèves au début de la période active toutes les deux lignes, pour les lignes n+1 et n+3 sur la figure 5. Le signal R̅S̅T̅R̅1̅ effectue l'initialisation de l'adresse lecture de la première mémoire.

Le signal d'autorisation d'écriture dans la mémoire 1 W̅E̅1̅, actif à l'état bas, fonctionne pour les lignes paires comme n ou n+2 de manière analogue à W̅E̅2̅ pour les lignes impaires.

Le signal W̅E̅1̅ est représenté en pointillés autour du point 112 car cette impulsion correspond à une ligne n+4 non représentée sur la figure 5.

Le signal R̅S̅T̅W̅1̅, actif à l'état bas, est le signal de l'initialisation de l'adresse en écriture de la première mémoire. Il comporte des impulsions brèves à chaque début de segment 101. Autour du point 129 le signal R̅S̅T̅W̅1̅ est représenté en pointillé car il correspond à la ligne n+4 non représentée sur la figure 5.

Le signal R̅S̅T̅W̅2̅ est un signal d'initialisation de l'adresse écriture de la seconde mémoire, actif à l'état bas il comporte pour chaque ligne paire une impulsion brève correspondant au début de la période de préparation de l'écriture de la seconde mémoire (signal W̅E̅2̅) et comme par exemple au point 109, au début des segments 101 des lignes impaires.

Le signal d'autorisation de lecture de la seconde mémoire, R̅E̅2̅, actif à l'état bas, comporte des impulsions comprises dans la partie active des lignes paires.

Le signal d'autorisation de lecture de la première mémoire R̅E̅1̅, actif à l'état bas comporte des impulsions durant les parties actives des impulsions impaires

Pour assurer une bonne synchronisation de la lecture et de l'écriture le dispositif selon la présente invention utilise un même signal de référence par exemple un F̅H̅1̅ pour générer les signaux d'autorisation d'écriture W̅E̅ et d'autorisation de lecture R̅E̅ pour chaque ligne. Par exemple l'impulsion F̅H̅1̅ commençant au point 105 permet de générer l'impulsion W̅E̅2̅ commençant au point 108 et R̅E̅2̅ commençant au point 113.

L'impulsion W̅E̅2̅ commençant au point 108 est élaborée à partir de l'impulsion F̅H̅1̅ commençant au point 105.

Dans un premier exemple de réalisation du dispositif selon la présente invention l'impulsion R̅E̅2̅ commençant au point 113 est élaborée à partir de l'impulsion F̅H̅1̅ commençant au point 105.

Dans un second exemple de réalisation du dispositif selon la présente invention l'impulsion R̅E̅2̅ commençant au point 113 est élaborée à partir de l'impulsion W̅E̅2̅ commençant au point 108.

Dans les deux cas, l'autorisation d'écriture W̅E̅2̅ et l'autorisation de lecture R̅E̅2̅ de la seconde mémoire sont synchronisées entre elles et ne sont donc pas affectées par un décalage de la synchronisation toujours possible des deux lignes successives. De même, pour la première mémoire, on utilise l'impulsion F̅H̅1̅ commençant au point 106 pour l'élaboration des impulsions d'autorisation d'écriture de la première mémoire W̅E̅1̅ commençant au point 114 et pour élaborer l'impulsion d'autorisation de lecture de la première mémoire R̅E̅1̅ commençant au point 115.

Le dispositif selon la présente invention permet de s'affranchir, lors du désembrouillage d'images de télévision, de la gigue, provenant par exemple des conditions de transmission affectant de façon sensible la périodicité de la synchronisation ligne régénérée (64»s ± ε).

Sur la figure 6, on peut voir un schéma explicatif de l'écriture dans un dispositif de mémorisation de lignes d'images vidéo comme par exemple la ligne n+1. La mémoire comporte une capacité de stockage de N mots numériques correspondant aux adresses 0 à N-1.

Dans un premier temps on effectue la préparation de l'écriture illustrée sur la figure 6a. La préparation commence au point 107 de la figure 5. La phase de préparation est nécessaire pour se trouver à l'adresse du point de coupure 104 au début de l'inscription du segment 102 de la ligne à inscrire. La position du point de coupure 104 est connue d'avance car elle est générée par, par exemple, un générateur pseudo-aléatoire commandé par un mot de commande. L'utilisation du générateur identique à l'émission et à la réception permet aux abonnés d'effectuer le désembrouillage d'émissions brouillées. La phase de la préparation consiste donc à écrire, l'information disponible entre l'adresse 0 et l'adresse correspondant au point de coupure 104 de la ligne n+1. L'information écrite dans cette partie de la mémoire n'a absolument aucune importance. L'information disponible à ce moment est dans le cas illustré sur la figure 5 la fin du segment 101 du signal de la ligne n.

Sur la figure 6b est illustrée l'inscription de la partie 102 de la ligne n+1 dans la mémoire. Cette inscription commence au point 108 de la figure 5. A la fin de la période de préparation on se trouve à l'adresse correspondant au point 104 de la ligne n+1. Or, c'est justement à partir de cette adresse qu'on doit, pour effectuer le désembrouillage, écrire le segment 102 de la ligne n+1 pour inverser les segments 101 et 102 lors de l'écriture dans la mémoire. Comme on peut le voir sur la figure 6b, la fin de la phase d'écriture de la période 102 de la ligne n+1, correspondant au point 110 de la figure 5, on obtient :
- entre l'adresse 0 et l'adresse du point de coupure 104 de la ligne n+1 une information concernant la fin du segment 101 de la ligne n ;
- entre l'adresse du point de coupure 104 de la ligne n+1 et l'adresse N-1 l'information concernant le segment 102 de la ligne n+1.

Comme on peut le voir sur la figure 6c, pour compléter le désembrouillage de la ligne n+1, il faut encore écrire entre l'adresse 0 et l'adresse du point de coupure 104 de la ligne n+1, l'information concernant le segment 101 de la ligne n+1. Cette écriture est effectuée entre les points 110 et 111 de la figure 5.

Ainsi, la connaissance du point de coupure 104 nous a permis d'effectuer le désembrouillage en plaçant le segment 101 de la ligne n+1 avant le segment 102 de la ligne n+1. Pour afficher la ligne n+1 il suffit d'effectuer la lecture entre l'adresse 0 et l'adresse N-1 de la mémoire.

Sur la figure 7 on peut voir l'exemple préféré de réalisation du dispositif de génération des signaux de commande lecture et écriture d'une des mémoires. Le dispositif comporte un échantillonneur 6. L'échantillonneur 6 reçoit d'une part un signal de synchronisation ligne et d'autre part le signal d'une horloge 203. La sortie de l'échantillonneur 6 est connectée à l'entrée initialisation d'un compteur 201. Le compteur 201 reçoit d'autre part les signaux de l'horloge 203. Les sorties du compteur 201 sont reliées à un décodeur 202. La sortie du décodeur 202 fournit un signal d'autorisation d'écriture W̅E̅1̅ ou W̅E̅2̅ et d'autre part est reliée à l'entrée d'initialisation du compteur 211 des points de l'image d'une ligne. D'autre part le compteur des points de l'image d'une ligne 211 reçoit les signaux de l'horloge 203. Les sorties du compteur des points d'une ligne de l'image 211 sont reliées aux entrées d'un décodeur 212. La sortie du décodeur 212 fournit le signal 206 d'autorisation de lecture R̅E̅1̅ ou R̅E̅2̅.

La présence d'un compteur 201 permet à partir d'un signal synchro-ligne 100 de réaliser la même synchronisation sur tous les décodeurs fonctionnant simultanément chez les utilisateurs. Les décodeurs 202 et 212 fournissent un signal 205 et 206 quand les compteurs respectivement 201 et 211 atteignent des valeurs prédéterminées.

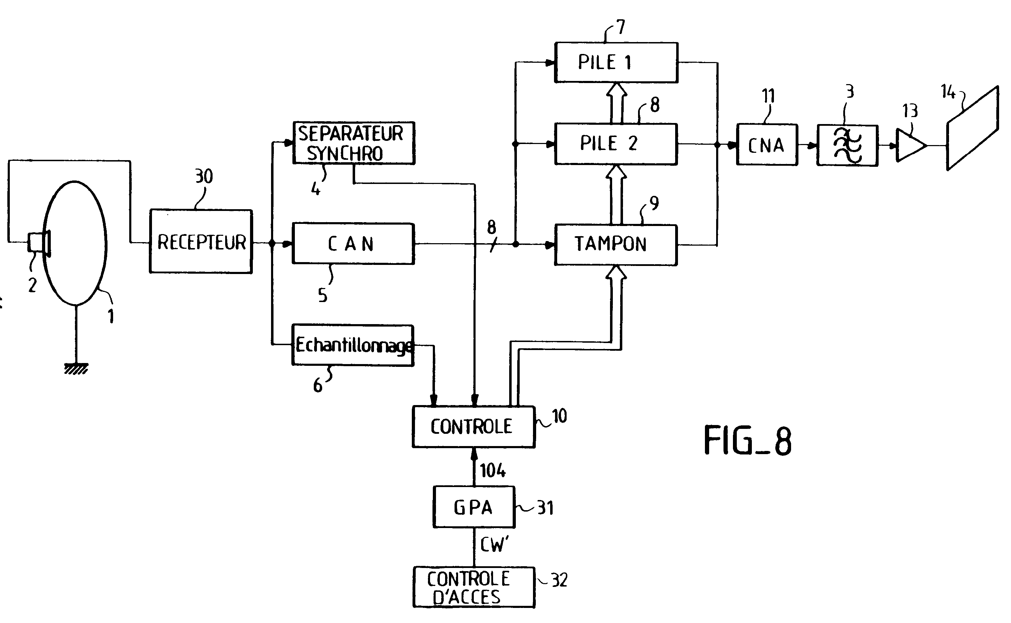

Sur la figure 8, on peut voir un exemple de réalisation d'un dispositif de réception d'émission de télévision comportant des moyens de désembrouillage de l'image. Le dispositif comporte une source de signal de télévision. Dans l'exemple illustré sur la figure 8, le dispositif 2 est un cornet associé à une antenne par exemple parabolique 1 destinée à recevoir les émissions provenant de satellites géostationnaires. La sortie du dispositif 2 est connectée à l'entrée d'un dispositif de réception 30 de type connu. La sortie du dispositif de réception 30 de type connu est connectée aux entrées d'un dispositif de séparation de la synchronisation 4, d'un convertisseur analogique-numérique 5 et d'un dispositif d'échantillonnage 6. La sortie du dispositif de séparation de synchronisation 4 et d'échantillonnage 6 sont connectées aux entrées d'un dispositif de contrôle 10. La sortie du convertisseur analogique-numérique 5 est connectée, par exemple par un bus de 8 bits aux entrées d'une première pile 7 de type premier-entré, premier-sorti (FIFO), à l'entrée d'une seconde pile 8 de type premier-entré, premier-sorti (FIFO) et à l'entrée d'une mémoire tampon 9. Le dispositif de contrôle 10 est connecté par un bus de contrôle à la première pile, à la deuxième pile 8 et à la mémoire tampon 9. Les sorties de la première pile 7, de la deuxième pile 8, de la mémoire tampon 9 sont reliées au dispositif d'exploitation des images désembrouillées. Dans l'exemple illustré sur la figure 8, les sorties connectées à l'entrée d'un convertisseur analogique-numérique 11. La sortie du convertisseur analogique-numérique 11 est connectée, à travers un filtre passe-bas 3 à l'entrée d'un amplificateur 13. La sortie de l'amplificateur 13 est connectée à l'entrée d'un tube à rayons cathodiques 14.

Dans le cas où on est en présence d'émissions brouillées, le dispositif de contrôle d'accès 32 fournit un mot de contrôle (CONTROL WORD ou CW en abréviation en terminologie anglo-saxonne) au générateur pseudo-aléatoire 31. Avantageusement, le mot de contrôle (CW′) tient compte du nombre de cycles effectués par générateur pseudo aléatoire depuis la dernière initialisation. Le générateur pseudo-aléatoire 31 fournit la position du point de coupure 104 au dispositif de contrôle 10. Le dispositif de contrôle 10 contrôle l'inscription et la lecture alternée de la première pile 7 et de la seconde pile 8. Cette écriture se fait par exemple conformément au processus décrit sur la figure 6. Quand on est en présence d'émissions non brouillées le dispositif de contrôle 10 inhibe l'écriture ou la lecture de la première pile 7 et de la deuxième pile 8. L'information passe directement par la mémoire tampon 9 sans être réarrangée. Dans l'exemple illustré sur la figure 8, on a par exemple utilisé les piles ayant une capacité de 1135 x 8 bits vendues sous la référence »PD41102 ou de capacité 910 x 8 bits vendues sous la référence »PD41101 par la Société NEC CORPORATION. Toutefois, l'invention n'est pas limitée à l'utilisation de piles pour le stockage des lignes d'images.

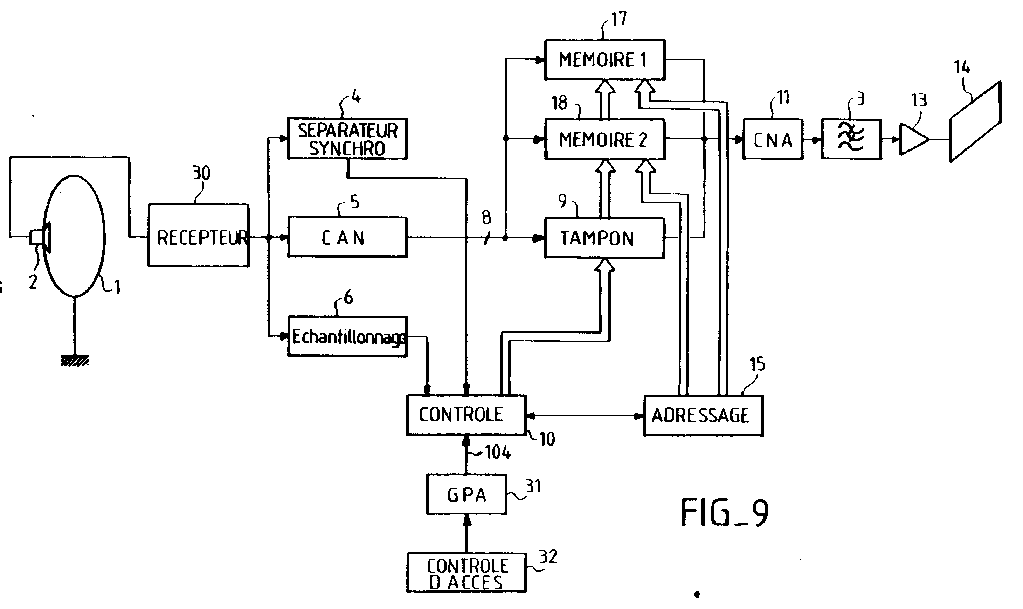

Sur la figure 9, on peut voir un exemple de réalisation d'un dispositif selon la présente invention utilisant un ensemble d'une première mémoire 17 et d'une seconde mémoire 18 à la place des piles 7 et 8. Les mémoires 17 et 18 sont par exemple des mémoires à accès direct, dynamique (DRAM en terminologie anglo-saxonne). L'adressage de la première mémoire 17 et de la seconde mémoire 18 est assuré par un circuit d'adressage 15 relié le bus d'adresse auxdites mémoires. Le circuit d'adresse 15 de type connu fournit les adresses d'écriture en mémoire d'échantillons numériques fournis par le convertisseur analogique-numérique 5. Le dispositif d'adressage 15 comporte par exemple des compteurs.

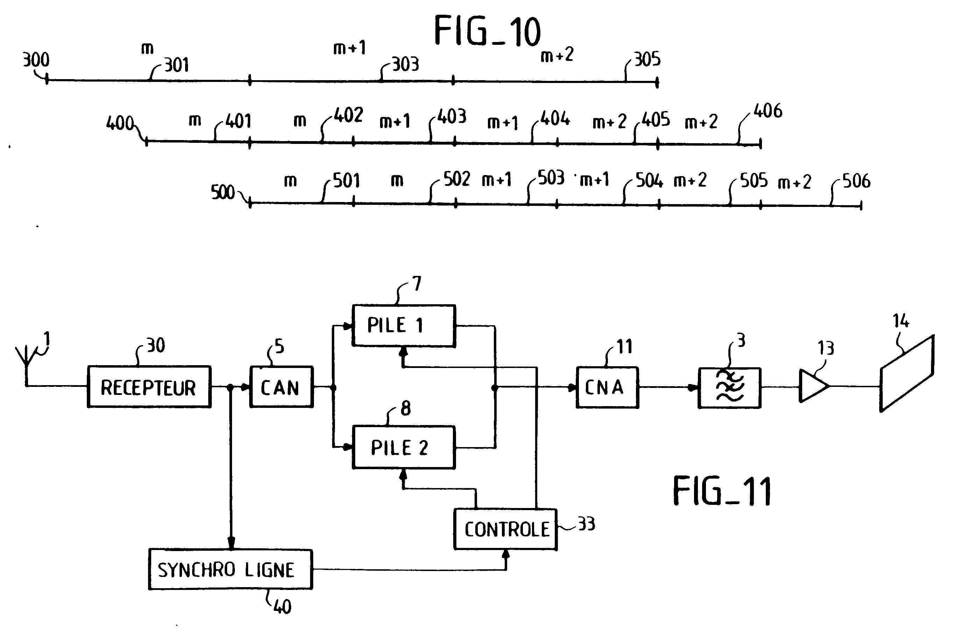

Sur la figure 10, on peut voir le principe d'utilisation d'un dispositif selon la présente invention pour réaliser le double balayage (double scan en terminologie anglo-saxonne). Le dispositif de télévision classique assure un balayage d'une demie image toutes les 1/25ème de secondes. Une image complète est donc balayée en 1/50ème de seconde dans les systèmes de télévision couleurs SECAM ou PAL (de 1/30ème de seconde dans les systèmes NTSC). La fréquence de balayage peut s'avérer insuffisante pour obtenir une impression de stabilité de l'image. Pour améliorer l'impression de stabilité des images on affiche successivement deux fois chaque image pendant le laps de temps normal (1/25ème ou 1/30ème de seconde) d'affichage d'une image. Pour ce faire l'image est stockée soit dans des mémoires lignes soit des mémoires trames. Le dispositif selon la présente invention permet une amélioration du dispositif de stockage dans la mémoire ligne.

Sur la ligne 300 on a représenté trois périodes n, n+1, n+2 d'un balayage de type classique.

Sur la ligne 400 on a illustré le double balayage de type connu.

Sur la ligne 500 on a illustré le double balayage selon la présente invention.

Sur la ligne 300 on a représenté l'affichage de trois images m, m+1, m+2 respectivement référencées 301,303 et 305.

Dans le dispositif de balayage de type connu, comme illustré sur la ligne 400, on commence à afficher une première image de la ligne m référencée 401 au milieu de l'affichage de la ligne m. Le premier affichage 401 de la ligne m est terminé simultanément avec la fin de l'affichage normal 301 de la ligne m. Pendant la moitié de l'affichage de la ligne m+1 303, on effectue un second affichage de la ligne m 402. Puis on reprend de la même façon au milieu de l'affichage de la ligne m+1 303 on effectue l'affichage 403 de la ligne m+1 et ainsi de suite. Dans le dispositif selon la présente invention les deux affichages successifs 501 et 502 de la ligne m sont effectués pendant la réception de la ligne m+1 303. De même, les affichages 503 et 504 de la ligne m+1 sont effectués pendant l'affichage 305 de la ligne m+2 et ainsi de suite. Dans le dispositif selon la présente invention, on utilise la même référence temporelle pour déclencher les affichages successifs de la même ligne 501 et 502. Ainsi on évite tout décalage dans l'affichage successif de deux lignes qui pourrait provenir de l'ordre de synchronisation entre deux lignes successives ou décaler une même ligne.

Un dispositif de réception d'émission de télévision mettant en oeuvre le procédé de la figure 10 est illustré sur la figure 11. Le dispositif de la figure 11 comporte une source de signal vidéo symbolisée par l'antenne 1, un dispositif de réception 30 de type connu. La sortie du dispositif de réception 30 est connectée d'une part à un dispositif de synchronisation des lignes 40 et d'autre part à un convertisseur analogique-numérique 5. La sortie du convertisseur analogique-numérique 5 est connectée aux entrées d'une première pile de type premier-entré, premier-sorti 7 et d'une seconde pile de type premier-entré, premier-sorti 8. La sortie du dispositif de synchronisation des lignes 40 est connectée à l'entrée d'un dispositif de contrôle 33. Les sorties du dispositif de contrôle 33 sont connectées aux entrées de contrôle des piles 7 et 8. Les sorties des piles 7 et 8 sont reliées à un dispositif d'exploitation des images. Dans l'exemple illustré sur la figure 11, le dispositif d'exploitation des images comporte un convertisseur numérique-analogique 11 connecté à un tube à rayons cathodiques 14 à travers un filtre passe-bas 3 et à un amplificateur 13.

Le dispositif de contrôle 33 permet l'écriture alternative d'une des piles 7 ou 8 pendant que l'autre est en lecture pour l'affichage d'une ligne. Pendant une séquence d'écriture dans une des piles 7 ou 8, l'autre pile 8 ou 7 est lue successivement deux fois. Le dispositif de contrôle 33 élabore à partir d'une référence temporelle unique par exemple fournie par le dispositif de synchronisation en lignes 40 le signal de contrôle d'écriture et deux signaux de contrôle de lecture pour chaque ligne d'affichage. L'élaboration de ces trois signaux de commande à partir d'une référence temporelle unique permet de s'affranchir de toute dérive de synchronisation entre deux lignes successives provenant notamment des conditions de transmission.

Il est bien entendu que l'utilisation d'un dispositif effectuant plus de deux affichages de chaque ligne ne sort pas du cadre de la présente invention.

Le dispositif selon la présente invention s'applique notamment à l'élaboration des signaux d'écriture et de lecture d'une mémoire destinée à stocker une ligne d'image vidéo à partir d'une référence temporelle commune.

L'invention s'applique principalement à la réalisation des dispositifs de désembrouillage d'émissions de télévision embrouillées notamment à péage.

## Revendications

1. Dispositif d'élaboration de signaux de contrôle d'écriture (W̅E̅) et de lecture (R̅E̅) dans une mémoire (7,8,17,18,20) d'un élément de signal vidéo, caractérisé par le fait qu'il comporte des moyens (10,21,22,33) d'élaboration desdits signaux de contrôle (R̅E̅, W̅E̅) pour le même élément du signal vidéo, à partir d'une seule référence temporelle.

2. Dispositif selon la revendication 1, caractérisé en ce que ladite référence temporelle est l'impulsion de synchronisation horizontale du signal vidéo.

3. Dispositif selon la revendication 1 ou 2, caractérisé par le fait que l'élément du signal vidéo est une ligne d'affichage.

4. Dispositif selon l'une des revendications 1 à 3, caractérisé par le fait qu'il comporte connectés en série des moyens (16) d'élaboration de la référence temporelle, les moyens (21) d'élaboration du signal de contrôle d'écriture (W̅E̅) et les moyens (22) d'élaboration du signal de contrôle de lecture (R̅E̅) de façon à ce que le signal de contrôle de lecture (R̅E̅) soit élaboré à partir du signal de contrôle d'écriture (W̅E̅).

5. Dispositif selon la revendication 1,2,3 ou 4, caractérisé par le fait que ledit dispositif est un dispositif numérique.

6. Dispositif selon la revendication 5, caractérisé par le fait que les moyens (16) d'élaboration de la référence temporelle, les moyens (21) d'élaboration des signaux de contrôle d'écriture (W̅E̅) et/ou les moyens (22) d'élaboration des signaux de contrôle de lecture (R̅E̅) comportent un compteur (201,211) dont la sortie est connectée à un décodeur (202,212).

7. Dispositif de désembrouillage d'émission de télévision, caractérisé par le fait qu'il comporte un dispositif selon l'une quelconque des revendications précédentes.

8. Dispositif de désembrouillage selon la revendication 7, caractérisé par le fait qu'il comporte deux piles (7,8) de type premier-entré, premier-sorti (FIFO) travaillant en alternance en écriture et en lecture.

9. Dispositif de désembrouillage selon la revendication 7, caractérisé par le fait qu'il comporte deux mémoires vives dynamiques (17,18) travaillant en alternance en écriture et en lecture connectées par un bus d'adresse à un dispositif d'adressage (15).

10. Téléviseur caractérisé par le fait qu'il comporte un dispositif de désembrouillage selon la revendication 7,8; ou 9.

11. Procédé d'élaboration de signaux de contrôle d'écriture (W̅E̅) et de lecture (R̅E̅) d'une ligne vidéo dans un dispositif de mémorisation (7,8,17,18,20) caractérisé par le fait qu'il comporte les étapes :
- d'élaboration d'une référence temporelle pour une ligne i
- d'élaboration directement ou indirectement à partir de la seule référence temporelle de la ligne i du signal de contrôle d'écriture de la ligne i (W̅E̅) et du signal de contrôle de lecture de la ligne i (R̅E̅).

12. Procédé selon la revendication 11, caractérisé par le fait qu'il comporte les étapes :
- d'élaboration du signal de contrôle d'écriture de la ligne i (W̅E̅) à partir de la référence temporelle de la ligne i
- d'élaboration du signal de contrôle de lecture de la ligne i (R̅E̅) à partir du signal de contrôle d'écriture de la ligne i (W̅E̅).

13. Procédé selon la revendication 11, caractérisé par le fait qu'il comporte l'étape d'élaboration des signaux de contrôle d'écriture (W̅E̅) et de lecture (R̅E̅) de la ligne i directement à partir de la référence temporelle de la ligne i.

## Patentansprüche

1. Vorrichtung für die Erzeugung von Signalen für die Steuerung des Schreibens (W̅E̅) und Lesens (R̅E̅) in einen bzw. aus einem Speicher (7, 8, 17, 18, 20) eines Elementes eines Videosignals, gekennzeichnet dadurch, daß sie Mittel (10, 21, 22, 33) zur Erzeugung der besagten Steuersignale (R̅E̅, W̅E̅) für ein und dasselbe Element des Videosignals aus einem einzigen Zeitreferenzsignal enthält.

2. Vorrichtung nach Anspruch 1, gekennzeichnet dadurch, daß das besagte Zeitreferenzsignal ein Horizontalsynchronisationsimpuls des Videosignals ist.

3. Vorrichtung nach Anspruch 1 oder 2, gekennzeichnet dadurch, daß das Element des Videosignals eine Bildzeile ist.

4. Vorrichtung nach einem der Ansprüche 1 bis 3, gekennzeichnet dadurch, daß sie, in Reihe geschaltet, Mittel (16) zur Erzeugung des Zeitreferenzsignals, die Mittel (21) zur Erzeugung des Signals für die Steuerung des Schreibens (W̅E̅) und die Mittel (22) zur Erzeugung des Signals für die Steuerung des Lesens (R̅E̅) enthält, derart, daß das Signal für die Steuerung des Lesens (R̅E̅) aus dem Signal für die Steuerung des Schreibens (W̅E̅) erzeugt wird.

5. Vorrichtung nach Anspruch 1, 2, 3 oder 4, gekennzeichnet dadurch, daß die besagte Vorrichtung eine digitale Vorrichtung ist.

6. Vorrichtung nach Anspruch 5, gekennzeichnet dadurch, daß die Mittel (16) zur Erzeugung des Zeitreferenzsignals, die Mittel (21) zur Erzeugung der Signale für die Steuerung des Schreibens (W̅E̅) und/oder die Mittel (22) zur Erzeugung der Signale für die Steuerung des Lesens (R̅E̅) einen Zähler (201, 211) umfassen, dessen Ausgang mit einem Dekoder (202, 212) verbunden ist.

7. Vorrichtung für die Entstörung von Fernsehsendungen, gekennzeichnet dadurch, daß sie eine Vorrichtung nach einem der vorhergehenden Ansprüche enthält.

8. Vorrichtung für die Entstörung nach Anspruch 7, gekennzeichnet dadurch, daß sie zwei Stapelspeicher (7, 8) vom Typ "First-In, First-Out" (FIFO) enthält, die abwechselnd im Schreib- und im Lesebetrieb arbeiten.

9. Vorrichtung für die Entstörung nach Anspruch 7, gekennzeichnet dadurch, daß sie zwei dynamische Speicher mit direktem Zugriff (17, 18) enthält, die abwechselnd im Schreib- und im Lesebetrieb arbeiten und über einen Adressenbus mit einer Adressiervorrichtung (15) verbunden sind.

10. Fernsehapparat, gekennzeichnet dadurch, daß er eine Vorrichtung für die Entstörung nach Anspruch 7, 8 oder 9 enthält.

11. Verfahren zur Erzeugung von Signalen für die Steuerung des Schreibens (W̅E̅) und des Lesens (R̅E̅) einer Videozeile in einer Speichervorrichtung (7, 8, 17, 18, 20), gekennzeichnet dadurch, daß es aus folgenden Etappen besteht:
- Erzeugung eines Zeitreferenzsignals für eine Zeile i,
- direkte oder indirekte Erzeugung des Signals für die Steuerung des Schreibens der Zeile i (W̅E̅) und des Signals für die Steuerung des Lesens der Zeile i (RE) allein aus dem Zeitreferenzsignal der Zeile i.

12. Verfahren nach Anspruch 11, gekennzeichnet dadurch, daß es aus folgenden Etappen besteht:
- Erzeugung des Signals für die Steuerung des Schreibens der Zeile i (W̅E̅) aus dem Zeitreferenzsignal der Zeile i;
- Erzeugung des Signals für die Steuerung des Lesens der Zeile i (R̅E̅) aus dem Signal für die Steuerung des Schreibens der Zeile i (WE).

13. Verfahren nach Anspruch 11, gekennzeichnet dadurch, daß es die Etappe der Erzeugung der Signale für die Steuerung des Schreibens (W̅E̅) und des Lesens (R̅E̅) der Zeile i, unmittelbar ausgehend von dem Zeitreferenzsignal der Zeile i, enthält.

## Claims

1. A read (R̅E̅) and write (W̅E̅) control signal generating device in respect of a memory (7, 8, 17, 18, 20) of a video signal element characterised by the fact that it has means (10, 21, 22, 33) for formulating and generating such control signals (R̅E̅, W̅E̅) in respect of the same video signal element based on one time reference.

2. A device pursuant to claim 1 characterised in that such time reference is the horizontal video signal synchronising pulse.

3. A device pursuant to claim 1 or 2 characterised by the fact that the video signal element is a display line.

4. A device pursuant to claim 1, 2 or 3 characterised by the fact that it has connected in series means (16) for generating the time reference, means (21) for generating the write control signal (W̅E̅) and means (22) for generating the read control signal (R̅E̅) such that the read control signal (R̅E̅) is formulated and generated based on the write control signal (W̅E̅).

5. A device pursuant to claim 1, 2, 3 or 4 characterised by the fact that the same is a digital device.

6. A device pursuant to claim 5 characterised by the fact that the means (16) for generating the time reference, together with the means (21) for generating the write control signals (W̅E̅) and/or means (22) for generating the read control signals (R̅E̅) have a counter (201, 211) where the output is connected to a decoder (202, 212).

7. A television transmission descrambling device characterised by the fact that it has a device pursuant to any of the foregoing claims.

8. A descrambling device pursuant to claim 7 characterised by the fact that it has two FIFO (First-In First-Out) type push-up stacks (7,8) operating on an alternate read/write basis.

9. A descrambling device pursuant to claim 7 characterised by the fact that it has two dynamic random access memories commonly abbreviated to "DRAM" (17, 18) operating on an alternate read/write basis connected via an address bus to an addressing device (15).

10. A television receiver characterised by the fact that it has a descrambling device pursuant to claim 7, 8 or 9.

11. A video line read (R̅E̅) and write (W̅E̅) control signal generating procedure in respect of a storage device (7, 8, 17, 18, 20) characterised by the fact that it involves the following stages :
- the generation of a time reference in respect of line i ;
- based on the single i time reference, the direct or indirect generation of the line i write control signal (W̅E̅) and line i read control signal (R̅E̅).

12. A procedure pursuant to claim 11 characterised by the fact that it involves the following stages :
- the generation of the line i write (W̅E̅) control signal based on the line i time reference ;
- the generation of the line i read (R̅E̅) control signal based on the line i write (W̅E̅) control signal.

13. A procedure pursuant to claim 11 characterised by the fact that it involves directly formulating and generating the line i write (W̅E̅) and read (R̅E̅) control signals based on the line i time reference.
